# EUROPEAN PATENT SPECIFICATION

(11) **EP 3 533 086 B1**
(45) Date of publication and mention of the grant of the patent: **09.12.2020**
(21) Application number: 17792136.8
(22) Date of filing: 24.10.2017
(51) Int. Cl.: H01L 31/0304, H01L 31/076

(54) **PHOTOVOLTAIC DEVICE**
PV-ELEMENT
DISPOSITIF PHOTOVOLTAÏQUE

(30) Priority: 25.10.2016 GB 201618024
(43) Date of publication of application: 04.09.2019
(73) Proprietor: IQE Plc., Cardiff CF3 0LW (GB); Nanyang Technological University, Singapore 639798 (SG); Imperial Innovations Limited, London SW7 2PG (GB)
(72) Inventor: YOON, Soon Fatt, 639798 (SG); TAN, Kian Hua, 639798 (SG); LOKE, Wan Khai, 639798 (SG); WICAKSONO, Satrio, 639798 (SG); EKINS-DAUKES, Nicholas, London SW7 2AZ (GB); THOMAS, Tomos, London SW7 2AZ (GB); JOHNSON, Andrew David, Caldicot NP26 3AD (GB)
(74) Representative: Abel & Imray
(86) International application number: PCT/GB2017/053200
(87) International publication number: WO 2018/078348

(56) References cited:
- US-A1- 2009 014 061
- US-A1- 2013 118 566
- US-A1- 2014 261 611

## Description

The present invention relates to photovoltaic diode devices.

### Background of the invention

As is known in the art, some solar cells comprise multiple stacked sub-cells, each comprising a photodiode, with the light to be absorbed passing through the sub-cells in turn, each sub-cell absorbing a different range of frequencies (or equivalently a different range of energies) due to each sub-cell having a different bandgap. These solar cells are often called multi-junction photovoltaic (PV) solar cells. Dilute nitride Group III-V semiconductors are of interest for application in high efficiency multi-junction PV devices as sub-cells with about a 1eV bandgap.
The absorption threshold of these semiconductors (i.e. the minimum photon frequency/energy that will excite an electron across the bandgap) can be adjusted by including a few percent of nitrogen (N) in the semiconductor, making them suitable candidates for fabricating sub-cells that absorb light in the near infrared.

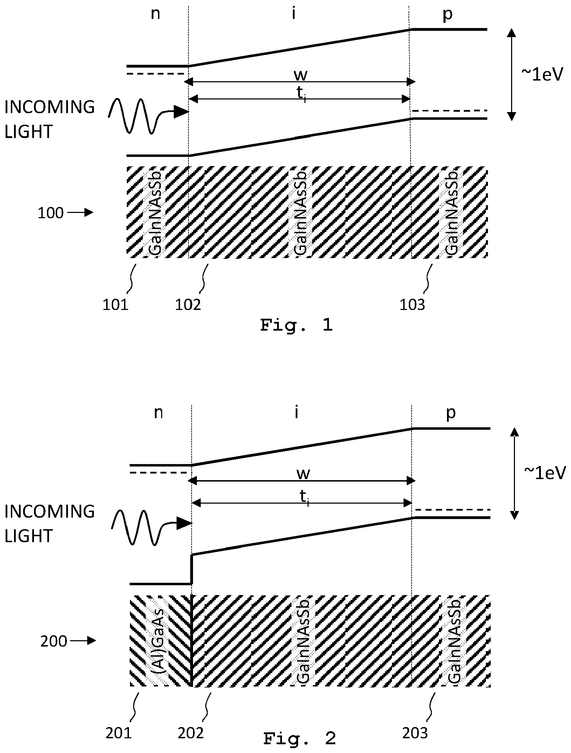

Dilute nitride Group III-V semiconductors can be grown lattice matched to GaAs when indium and/or antimony are included in the material. The incorporation of N into GaInAsSb tends to reduce the minority carrier lifetime to less than 1ns, resulting in diffusion lengths of 200nm or less. The conventional approach to solving the problem of short diffusion lengths has been to grow depleted n-i-p junctions, exploiting drift transport of the photo-generated carriers in the depletion region. See for example Jenny Nelson, "The Physics of Solar Cells" from the series "Properties of Semiconductor Materials" 1st Edition (September 5, 2003),published by Imperial College Press (ISBN-10:1860943497, ISBN-13:978-1860943492) The n-i-p diode 100 of such a sub-cell is illustrated in Figure 1, which shows both the semiconductor material layers forming the n-i-p junction and the corresponding band structure of the material against distance perpendicular to the layers.

In this device 100, the diode junction is formed by three layers. The top, emitter layer 101 of the junction is n-type dilute nitride GaInNAsSb emitter layer. "top" is used to indicate the layer of the junction which receives the incident light first (in the diagram of Figure 1 the light comes, in use, from the left, as indicated by the sinuous arrows.). As is known in the art it may be overlaid (i.e. to the left in the diagram) with other sub-cells and other layers of a solar cell, for example window and electrode layers. The next two layers 102 and 103 "down" (i.e. to the right in the Figure) are of the same composition dilute nitride GaInNAsSb material as the emitter layer. However base layer 103 is p-type and intrinsic (i) layer 102 is undoped, or is significantly less actively doped than layers 101 and 103. Here it is important that the active background doping concentration of the intrinsic layer is sufficiently low to ensure the depletion width (marked w in Figure 1) of the diode junction formed by the device is equal or greater than the absorption depth of photons in the GaInNAsSb semiconductor, so that the light is absorbed in the depletion region where the photo-carriers generated will be separated by drift caused by the electric field of the depletion region. i.e. that w > 1/α where w is the depletion width, α the absorption coefficient (α is the reciprocal of the absorption length). Achieving a sufficiently large w can be hard and typically background doping levels as low as 10¹⁵cm⁻³ are preferred in this material. Also, in this n-i-p diode, it is important that the n-type emitter layer 101 is kept thin, since in the absence of long range diffusive transport in that layer, carriers photo-generated in that layer 101 will not be efficiently transported across the thickness of the layer and will be lost there to recombination . (Note that the depletion region marked by the arrow w in the Figure extends just into the emitter and base regions and so is slightly longer than the thickness ti of the intrinsic region.)

United States patent application no. US-A-2009/014061 describes a high efficiency triple-junction solar cell and method of manufacture therefor. Junctions are formed between different types of III-V semiconductor alloy materials, one alloy of which contains a combination of an effective amount of antimony (Sb) with gallium (Ga), indium (In), nitrogen (N, the nitride component) and arsenic (As) to form the dilute nitride semiconductor layer GaInNAsSb which has particularly favorable characteristics in a solar cell. In particular, the bandgap and lattice matching promote efficient solar energy conversion.

United States patent application no. US-A-2013/118566 describes multijunction solar cells having at least four subcells. At least one of the subcells comprises a base layer formed of an alloy of one or more elements from group III on the periodic table, nitrogen, arsenic, and at least one element selected from the group consisting of Sb and Bi, and each of the subcells is substantially lattice matched.

United States patent application no. US-A-2014/261611 describes an optoelectronic device comprising a photovoltaic cell. The photovoltaic cell comprises a space-charge region, a quasi-neutral region, and a low bandgap absorber region (LBAR) layer or an improved transport (IT) layer at least partially positioned in the quasi-neutral region of the cell.

### Summary of the invention

According to the present invention there is provided a photovoltaic diode comprising:
an emitter layer of doped Group III-V semiconductor material, having a first conductivity type and a first bandgap in at least part of the layer,
an intrinsic layer of dilute nitride Group III-V semiconductor material having a composition given by the formula Ga_{1-z}In_{z}NₓAs_{y}Sb_{i-x-y}, where 0 < z < 0.20, 0.01 < x < 0.05, and y > 0.80 having a second bandgap,
a base layer of semiconductor material having a third bandgap and a second conductivity type opposite to the first conductivity type,
wherein the emitter, intrinsic and base layers form a diode junction, and
wherein the first bandgap is greater than the second bandgap,
wherein the emitter layer comprises a wide bandgap emitter layer of Group III-V semiconductor material having the first bandgap and a narrow bandgap emitter layer between the wide bandgap emitter layer and the intrinsic layer, the narrow gap emitter layer having the first conductivity type and being of a dilute nitride Group III-V semiconductor material having composition given by the formula Ga1-zInzNxAsySb1-x-y, where 0 < z < 0.20, 0.01 < x < 0.05, and y > 0.80, wherein the narrow gap emitter layer has a fourth bandgap that is smaller than the first bandgap,
wherein the narrow bandgap emitter layer is less in thickness than a diffusion length of the minority carriers.

That difference in bandgap provides a barrier for minority photo-generated carriers.

The base layer may be a layer of dilute nitride Group III-V semiconductor material having a composition given by the formula Ga_{1-z}In_{z}NₓAs_{y}Sb_{i-x-y}, where 0 < z < 0.20, 0.01 < x < 0.05, and y > 0.80.

The fourth bandgap may be the same as the second bandgap. The fourth bandgap may be between the first and second bandgaps. The narrow bandgap emitter layer may be lattice matched to the wider bandgap emitter layer. The narrow bandgap emitter layer may be lattice matched to the intrinsic layer. The narrow bandgap emitter layer may be less in thickness than 200nm. The narrow bandgap emitter layer may be 100nm in thickness.

The intrinsic and base layers may have the same composition of semiconductor material. The intrinsic and base layers may have the same band gap as each other.

The base layer may comprise a graded dilute nitride Group III-V semiconductor material layer having a composition and bandgap graded through the thickness of the graded layer, the composition through the graded layer being within the formula Ga_{1-z}In_{z}NₓAs_{y}Sb_{i-x-y}, where 0 < z < 0.20, 0.01 < x < 0.05, and y > 0.80. The bandgap of the graded layer of the base may have an interface with the intrinsic layer and at that interface may have a bandgap equal to that of the intrinsic layer at that interface. The bandgap of the graded layer of the base may have an interface with the intrinsic layer and at that interface may have a same composition to that of the intrinsic layer at that interface.

The emitter layer may comprise a layer of gallium arsenide. The emitter layer may comprise a layer of aluminium gallium arsenide.

The intrinsic layer may have a bandgap in the range 0.7 to 1.4 eV. The base layer may have a bandgap in the range 0.7 to 1.0 eV.

The emitter, intrinsic and base layers may be lattice matched to each other.

The present invention also provides a solar cell comprising the photovoltaic diode.

The present invention further provides a multijunction photovoltaic device comprising the photovoltaic diode.

The present invention also provides a multijunction photovoltaic device comprising a first one of the said photovoltaic diodes as one of its junctions, and a second one of the said photovoltaic diodes as one of its junctions, wherein the base of the first and second photovoltaic diodes have different bandgaps.

The present invention further provides a method of generating electricity using the photovoltaic diode, comprising:
directing light into the photovoltaic diode in through the emitter layer in the direction of the intrinsic and base layers,
absorbing the light in the intrinsic layer to generate photo carriers, and
the diode separating the photo-carriers to generate electricity.

### Brief description of the drawings

Examples of the invention will now be described, with reference to the accompanying drawings, of which:
- FIGURE 1: shows the layers and band diagram of a known n-i-p photovoltaic diode,
- FIGURE 2: shows the layers and band diagram of the junction of an exemplary heterostructure n-i-p photovoltaic diode,
- FIGURE 3: shows the layers and band diagram of the junction of another example of a heterostructure n-i-p photovoltaic diode,
- FIGURE 4: shows unclaimed examples comprising the layers and band diagram of the junction of an exemplary graded heterostructure n-i-p photovoltaic diode, and
- FIGURE 5: is a cross-section of a multi-junction photovoltaic device.

### Examples of the invention

Figure 2 shows the layers and a band diagram of a first example of a heterostructure n-i-p photovoltaic diode in accordance with the invention. This may form, for example, a sub-cell of a multi-junction photovoltaic device. In this diode 200, there are three layers 201, 202 and 203 forming the diode junction. The "top", emitter layer 201 of the junction is an n-type layer of, in this example, GaAs (although alternatively AlGaAs may be used). The middle, intrinsic layer 202 and base layer 203 are both of a dilute nitride GaInNAsSb material. The base layer 203 is a p-type layer and the intrinsic layer 202 is undoped, or is significantly less actively doped than layers 201 and 203. The materials of all three layers are lattice matched, i.e. have the same lattice parameter or are close enough in lattice parameter not to cause dislocations to form (or not to "plastically relax" as this is sometimes known) when the materials are grown epitaxially. As is known, lattice matching with slightly differing lattice parameters can be achieved in both thick layers and in thin layers; for the latter the difference in lattice parameter can be greater as long as the critical thickness of the layer is not exceeded. The base layer and intrinsic layers preferably have the same bandgap.

The layers may be grown in turn epitaxially on a lattice matched substrate. This may be in the order base layer 203, then intrinsic layer 202, then emitter layer 201. However, as is known in the art, the layers could be grown on a substrate in the other direction, and then removed from that substrate and turned over before being mounted on another substrate.

A preferred range for the composition of dilute nitride GaInNAsSb layers are given by the formula Ga_{1-z}In_{z}NₓAs_{y}Sb_{i-x-y}, where 0 < z < 0.20, 0.01 < x < 0.05, and y > 0.80. The base layer 203 and the intrinsic layer preferably have the same composition, but may be of different compositions, which is also possible even in cases where they have the same band gap as well as being lattice matched to each other (given the number of different elements from which the material is formed).

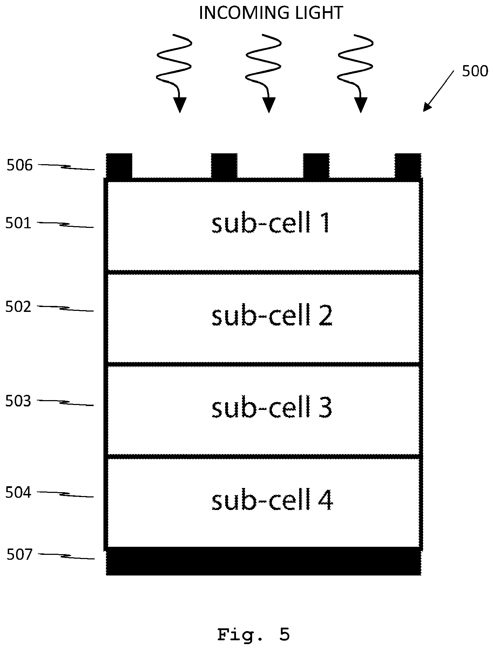

Again, as is known in the art, the top layer 201 may be overlaid (i.e. to the left in the diagram) with other sub-cells (see Figure 5 and the related description later below) and other layers of a solar cell, for example window and electrode layers. (The "top" layer is again meant in the sense of the layer of the junction which receives the incident light first - in Figure 2 the light comes from the left).

As with the known example of Figure 1, it is preferable that the active background doping concentration in the intrinsic layer 202 is sufficiently low to ensure the depletion width (again marked w in Figure 2) is equal or greater than the absorption depth of photons in the semiconductor, i.e. that w > 1/α. A doping level of around 10¹⁵ cm⁻³ is preferred in the example of Figure 2; 10¹⁴ cm⁻³ may be better still, although would be harder to achieve. The preferred doping levels for the emitter layer 201 and base layer 203 in the example of Figure 2 are 5 x 10¹⁷ to 1 x 10¹⁹ cm⁻³ and 5 x 10¹⁶ to 1 x 1018 cm⁻³ respectively.

In the present example, i.e. that of Figure 2, it is notable that the n-type emitter layer 201 has a bandgap greater than that of the intrinsic layer 202.

Now, with the known n-i-p homojunction described above with respect to Figure 1, it was important that its n-type emitter layer 101 be kept thin, since in the absence of long range diffusive transport, carriers photo-generated in the n-type layer 101 would not be transported across the thickness of that layer without recombination. However, in this example, with the bandgap of the n-type emitter layer 201 being greater than that of the intrinsic layer 202, the n-type emitter layer 201 does not absorb a significant proportion of the photons that pass through it, so photo-carriers are not created, and the photons are instead absorbed in the intrinsic layer 202, which has a smaller bandgap. So one effect of the difference in bandgap is that it is no longer a requirement to keep the n-type layer thin; for example, thicknesses of over 100 nm may be used for the n-type emitter layer 201. In general, the fabrication and structure of many layered devices is usually beset by numerous and often competing requirements so the relaxation of this requirement in this device may have advantages when the device of Figure 2 forms part of such a device. For example thicker layers often have better material properties, for example the bulk is not subject to diffusion of dopants from neighbouring layers.

Also, a useful advantage of having GaAs or AlGaAs for the material of the n-layer 201 is that those are compatible with having an overlying tunnel junction and barrier for minority carrier holes, which are typically be used between the sub-cells of a multijunction solar cell. In such one example of compatibility the next layer above the next later above 201 is formed of GaAs or AlGaAs.

It would also be possible to have a heterostructure "p-i-n" diode in accordance with the invention. An example would be similar to that of Figure 2 with the emitter, intrinsic and base layers being respectively of the same materials as the those layers 201, 202 and 203 of n-i-p diode of Figure 2, but with the emitter being doped p-type and the base layer being doped n-type, and indeed it functions in the same way. (i.e., in this example the conductivity types (n-type/p-type) of the emitter and base are opposite to those in the example of Figure 2).

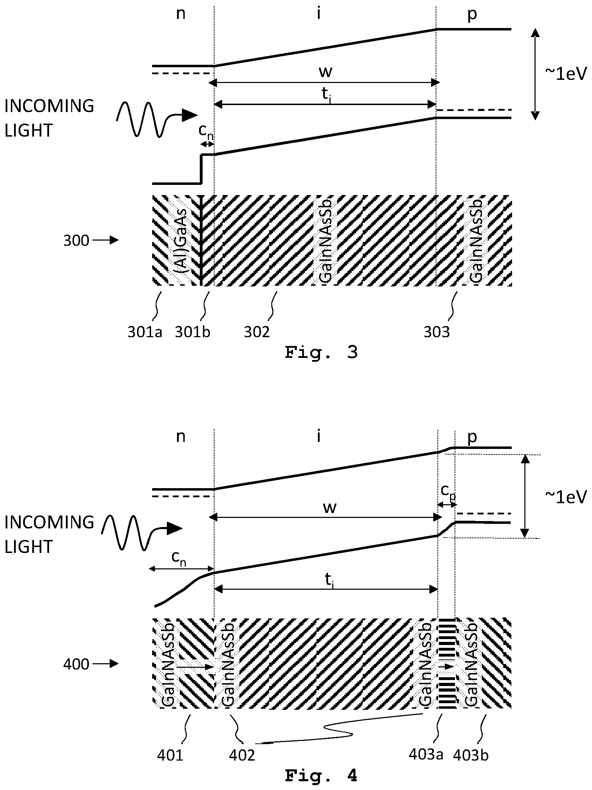

Figure 3 shows the layers and a band diagram of a second example of a heterostructure n-i-p photovoltaic diode 300 in accordance with the invention. Again, this may form a sub-cell of a multi-junction photovoltaic device. The diode has an n-type emitter layer 301, and intrinsic layer 302 and a p-type base layer 303. These are generally of the same materials as the example of Figure 2, but in this case the emitter layer 301 has two layers: a wide bandgap emitter layer 301a and a narrow bandgap emitter layer 301b, both of which are doped n-type. Layer 301b is between layers 301a and 302. As with the example of Figure 2 in this example the wide bandgap emitter layer 301a is of GaAs, or AlGaAs, material. The narrow bandgap emitter layer 301b is of dilute nitride GaInNAsSb. It has a smaller bandgap than the wide bandgap emitter layer and preferably one that is equal to that of the intrinsic layer 302 (although alternatively it may have a bandgap between that of the main emitter layer 301a and the intrinsic layer 302). Preferably the narrow bandgap emitter layer 301b is lattice matched to the main emitter layer 301a and intrinsic layer 302.

The narrow bandgap emitter layer 301b, because it has a narrower bandgap than main emitter layer 301a absorbs photons passing on from the wide bandgap emitter layer that have an energy greater than the bandgap of the narrow bandgap gap emitter layer, to produce electron-hole pairs. Because the thickness cₙ (typically 10nm) of the narrow bandgap emitter layer 301b is less than the absorption length for the photons, not all such photons are absorbed in the narrow bandgap emitter layer 301b and the remainder pass on to the intrinsic layer 302 where they are absorbed, as in the previous examples. Although the narrow bandgap emitter layer 301b is doped, its thickness in this example is equal to or thinner than the diffusion length of the photo carriers in the material of that layer, so quite quickly the electrons diffuse or drift into the wide bandgap emitter layer 301a and, importantly, the minority carrier holes diffuse into the depletion region (where they are transported by the electric field of the depletion region across the intrinsic region 302 to the base 303). The step in the valance band edge between the narrow bandgap emitter layer 301b to the wide bandgap emitter later 301a acts as a barrier to those holes diffusing into the wide bandgap emitter layer 301a, where of course they would recombine with the electrons. In this example then, the overall region that absorbs the photons is that of combined lengths cₙ and w (noting of course that cₙ and w overlap slightly). In practice this provides extra length for absorption, since as noted above, the practical length of w is limited by the background doping level of the intrinsic region that is achievable (which is the same as for the example of Figure 2) and that length w is not very much longer than the absorption length of light in these materials, making the extra length cₙ significant.

Figure 4 shows unclaimed examples comprising the layers and a band diagram of an example of a heterostructure n-i-p photovoltaic diode 400. This may form a sub-cell of a multi-junction photovoltaic device. The diode has an n-type emitter layer 401, and intrinsic layer 402 and a p-type base layer 403a/403b. In this example a grade 401, 403a in composition is provided in each of the emitter and/or base regions. A grade in doping may also be used, as is the case in this example.

In the example of Figure 4 all the layers are of various compositions of GaInNAsSb. The composition of intrinsic layer is preferably as in the examples above, which gives the material a bandgap energy of -1.0 eV. The compositional grade 401 widens the bandgap with distance from the interface with the intrinsic later. As shown, there is preferably no step change in the bandgap at that interface. The bandgap preferably widens to equal that of the next later above, which for example may be of GaAs or AlGaAs. An alternative material for the emitter 401 is a compositional grade of AlGaAs.

Similarly the compositional grade 403a narrows the bandgap from its interface with the intrinsic later until it equals that of base layer 403b.

In this example, the grade layers also have grades in the dopant levels, increasing away from the respective interfaces with the intrinsic region. As there is active doping in these regions the depletion region terminates a short distance into each.

The compositional graded layers each further extend the collection length in the solar cell by inducing an electric field in the region of cₙ and cₚ, resulting in an active collection length of the combination of cₙ, w, and cₚ. (Note that there is a small overlap between w and cₙ, and between w and cₚ.) Conveniently, the compositional and doping grades 401 and 403a also provide an electric field to drift the minority carriers, leading to a higher photo-carrier collection efficiency.

The design constraints are that (1) that the thickness (cₙ & cₚ) of graded layers 401 and 403a should correspond to the combination of the graded semiconductor materials, doping grade and diffusion length of the doped semiconductor and (2) the intrinsic region 402 thickness ti is determined by the background impurity concentration level, to ensure that the intrinsic layer 402 remains depleted at the operating voltage.

The compositional grade of the base layer may also be used, for example, in the embodiments of Figures 2 and 3.

Note that in Figure 2, the band diagram shows an ideal band alignment where a barrier is formed in the valance band but a barrier may also form in the conduction band, depending on the composition of the GaInAsSb material. In Figure 3 some band-bending can be expected at the interface between 301a and 301b, with its spatial extent determined by the free carrier density in the n-type layer. In the unclaimed examples of Figure 4, the profile of the valance band can be controlled by simultaneously controlling the doping level and semiconductor composition. Figure 4 shows the typical example with homogenous n-type doping in layer 401.

Figure 5 shows an exemplary photovoltaic device 500 having several subcells. In this example there are four subcells connected in series (or "tandem" as this is often called for these devices). A first subcell 501 has an active light absorbing region of AlGaInP, which has a very wide bandgap and absorbs the incident light with energy > ∼1.9 eV. A second subcell 502 has an active light absorbing region of Ga(In)As, which has a narrower bandgap than that of 501 and absorbs the incident light with energy from 1.4 eV to 1.9 eV passing through to that subcell from subcell 501. A third subcell 503 is a subcell according to the invention, for example, one of those described with reference to Figure 2, 3 or 4, above. Here where the emitter 201/301a is also of GaAs it of course has the same bandgap as subcell 502. This means that light that would be absorbed by the GaAs emitter have already been absorbed by subcell 502 and 501. So no light is wasted by being absorbed in the emitter 201/301a. The fourth subcell 504 has an active light absorbing region of Ge which has the narrowest bandgap among all subcells and absorbs incident light with energy from 0.66 eV to 1.0 eV, which pass through to that subcell from subcell 503. An alternative for subcell 504 is having a second n-i-p diode as described above, but with a smaller bandgap in the intrinsic layer than for subcell 503.

The above devices may be fabricated by known techniques such as molecular beam epitaxy (MBE) or metal organic vapour phase epitaxy(MOVPE). The International patent application published as no. WO2009/157870 discloses a method of fabrication of the dilute nitride materials.

## Claims

1. A photovoltaic diode, 300, comprising:
an emitter layer, 301, of doped Group III-V semiconductor material, having a first conductivity type and a first bandgap in at least part of the layer,
an intrinsic layer, 302, of dilute nitride Group III-V semiconductor material having a composition given by the formula Ga_{1-z}In_{z}NₓAs_{y}Sb_{1-x-y}, where 0 < z < 0.20, 0.01 < x < 0.05, and y > 0.80 having a second bandgap,
a base layer, 303, of semiconductor material having a third bandgap and a second conductivity type opposite to the first conductivity type,
wherein the emitter, intrinsic and base layers form a diode junction, and
wherein the first bandgap is greater than the second bandgap,
wherein the emitter layer comprises a wide bandgap emitter layer, 301a, of Group III-V semiconductor material having the first bandgap and a narrow bandgap emitter layer, 301b, between the wide bandgap emitter layer and the intrinsic layer, the narrow gap emitter layer having the first conductivity type and being of a dilute nitride Group III-V semiconductor material having composition given by the formula
Ga_{1-z}In_{z}NₓAs_{y}Sb_{1-x-y}, where 0 < z < 0.20, 0.01 < x < 0.05, and y > 0.80, wherein the narrow gap emitter layer has a fourth bandgap that is smaller than the first bandgap,
**characterized in that** the narrow bandgap emitter layer is less in thickness than a diffusion length of the minority carriers.

2. A photovoltaic diode as claimed in claim 1, wherein the base layer is a layer of dilute nitride Group III-V semiconductor material having a composition given by the formula Ga_{1-z}In_{z}NₓAs_{y}Sb_{1-x-y}, where 0 < z < 0.20, 0.01 < x < 0.05, and y > 0.80.

3. A photovoltaic diode as claimed in claim 1, wherein the fourth bandgap is the same as the second bandgap.

4. A photovoltaic diode as claimed in claim 1, wherein the fourth bandgap is between the first and second bandgaps.

5. A photovoltaic diode as claimed in any one of claims 1 to 4, wherein the narrow bandgap emitter layer is lattice matched to the wider bandgap emitter layer.

6. A photovoltaic diode as claimed in any one of claims 1 to 5, wherein the narrow bandgap emitter layer is lattice matched to the intrinsic layer.

7. A photovoltaic diode as claimed in any one of claims 1 to 6, wherein the narrow bandgap emitter layer is less in thickness than 200nm.

8. A photovoltaic diode as claimed in claim 7, wherein the narrow bandgap emitter layer is 100nm in thickness.

9. A photovoltaic diode as claimed in any preceding claim, wherein the intrinsic and base layers have the same composition of semiconductor material.

10. A photovoltaic diode as claimed in any preceding claim, wherein the intrinsic and base layers have the same band gap as each other.

11. A photovoltaic diode as claimed in any one of claims 1 to 8, wherein the base layer comprises a graded dilute nitride Group III-V semiconductor material layer having a composition and bandgap graded through the thickness of the graded layer, the composition through the graded layer being within the formula Ga_{1-z}In_{z}NₓAs_{y}Sb_{1-x-y}, where 0 < z < 0.20, 0.01 < x < 0.05, and y > 0.80.

12. A photovoltaic diode as claimed in claim 11, wherein the bandgap of the graded layer of the base has an interface with the intrinsic layer and at that interface has a bandgap equal to that of the intrinsic layer at that interface.

13. A photovoltaic diode as claimed in claim 11 or claim 12, wherein the bandgap of the graded layer of the base has an interface with the intrinsic layer and at that interface has a same composition to that of the intrinsic layer at that interface.

14. A photovoltaic diode as claimed in any preceding claim, wherein the emitter layer comprises a layer of gallium arsenide, and wherein the emitter layer comprises a layer of aluminium gallium arsenide.

15. A photovoltaic diode as claimed in any preceding claim, wherein the intrinsic layer has a bandgap in the range 0.7 to 1.4 eV, and wherein the base layer has a bandgap in the range 0.7 to 1.0 eV.

16. A photovoltaic diode as claimed in any preceding claim, wherein the emitter, intrinsic and base layers are lattice matched to each other.

17. A solar cell comprising a photovoltaic diode as claimed in any preceding claim.

18. A multijunction photovoltaic device comprising a photovoltaic diode as claimed in any one of claims 1 to 16 as one of its junctions.

19. A multijunction photovoltaic device comprising a first photovoltaic diode as claimed in any one of claims 1 to 16 as one of its junctions, and comprising a second photovoltaic diode as claimed in any one of claims 1 to 16 as one of its junctions, wherein the base of the first and second photovoltaic diodes have different bandgaps.

20. A method of generating electricity using a photovoltaic diode as claimed in any one of claims 1 to 16 comprising:
directing light into the photovoltaic diode in through the emitter layer in the direction of the intrinsic and base layers,
absorbing the light in the intrinsic layer to generate photo carriers, and
the diode separating the photo-carriers to generate electricity.

## Patentansprüche

1. Photovoltaikdiode, 300, mit:
einer Emitterschicht, 301, aus dotiertem Gruppe-III-V-Halbleitermaterial mit einem ersten Leitfähigkeitstyp und einer ersten Bandlücke in mindestens einem Teil der Schicht,
einer intrinsischen Schicht, 302, aus einem verdünnten Nitrid-Gruppe-III-V-Halbleitermaterial mit einer Zusammensetzung, die gegeben ist durch die Formel Ga_{1-z}In_{z}NₓAs_{y}Sb_{1-x-y}, wobei 0 < z < 0,20, 0,01 < x < 0,05 und y > 0,80, mit einer zweiten Bandlücke,
einer Basisschicht, 303, aus einem Halbleitermaterial mit einer dritten Bandlücke und einem zweiten Leitfähigkeitstyp entgegengesetzt zu dem ersten Leitfähigkeitstyp,
bei der die Emitterschicht, die intrinsische Schicht und die Basisschicht einen Diodenübergang bilden und
bei der die erste Bandlücke größer als die zweite Bandlücke ist,
bei der die Emitterschicht eine Emitterschicht mit einer breiten Bandlücke, 301a, aus einem Gruppe-III-V-Halbleitermaterial mit der ersten Bandlücke und eine Emitterschicht mit einer schmalen Bandlücke, 301b, zwischen der Emitterschicht mit einer breiten Bandlücke und der intrinsischen Schicht aufweist, wobei die Emitterschicht mit einer schmalen Bandlücke den ersten Leitfähigkeitstyp aufweist und aus einem verdünnten Nitrid-Gruppe-III-V-Halbleitermaterial mit einer Zusammensetzung, die gegeben ist durch die Formel Ga_{1-z}In_{z}NₓAs_{y}Sb_{1-x-y}, wobei 0 < z < 0,20, 0,01 < x < 0,05 und y > 0,80, besteht, wobei die Emitterschicht mit schmaler Bandlücke eine vierte Bandlücke aufweist, die kleiner als die erste Bandlücke ist,
**dadurch gekennzeichnet, dass**
die Emitterschicht mit schmaler Bandlücke eine geringere Dicke als eine Diffusionslänge der Minoritätsladungsträger aufweist.

2. Photovoltaikdiode nach Anspruch 1, bei der die Basisschicht eine Schicht aus einem verdünnten Nitrid-Gruppe-III-V-Halbleitermaterial mit einer Zusammensetzung, die gegeben ist durch die Formel Ga_{1-z}In_{z}NₓAs_{y}Sb_{1-x-y}, wobei 0 < z < 0,20, 0,01 < x < 0,05 und y > 0,80, ist.

3. Photovoltaikdiode nach Anspruch 1, bei der die vierte Bandlücke dieselbe wie die zweite Bandlücke ist.

4. Photovoltaikdiode nach Anspruch 1, bei der die vierte Bandlücke zwischen der ersten und der zweiten Bandlücke liegt.

5. Photovoltaikdiode nach einem der Ansprüche 1 bis 4, bei der die Emitterschicht mit schmaler Bandlücke an die Emitterschicht mit breiter Bandlücke gitterangepasst ist.

6. Photovoltaikdiode nach einem der Ansprüche 1 bis 5, bei der die Emitterschicht mit schmaler Bandlücke an die intrinsische Schicht gitterangepasst ist.

7. Photovoltaikdiode nach einem der Ansprüche 1 bis 6, bei der die Emitterschicht mit schmaler Bandlücke eine geringere Dicke als 200 nm aufweist.

8. Photovoltaikdiode nach Anspruch 7, bei der die Emitterschicht mit schmaler Bandlücke eine Dicke von 100 nm aufweist.

9. Photovoltaikdiode nach einem der vorhergehenden Ansprüche, bei der die intrinsische Schicht und die Basisschicht dieselbe Zusammensetzung eines Halbleitermaterials aufweisen.

10. Photovoltaikdiode nach einem der vorhergehenden Ansprüche,
bei der die intrinsische Schicht und die Basisschicht jeweils dieselbe Bandlücke aufweisen.

11. Photovoltaikdiode nach einem der Ansprüche 1 bis 8, bei der die Basisschicht eine abgestufte verdünnte Nitrid-Gruppe-III-V-Halbleitermaterialschicht mit einer Zusammensetzung und einer Bandlücke, die durch die Dicke der abgestuften Schicht abgestuft sind, aufweist, wobei die Zusammensetzung durch die abgestufte Schicht innerhalb der Formel Ga_{1-z}In_{z}NₓAs_{y}Sb_{1-x-y} liegt, wobei 0 < z < 0,20, 0,01 < x < 0,05 und y > 0,80.

12. Photovoltaikdiode nach Anspruch 11, bei der die Bandlücke der abgestuften Schicht der Basis eine Grenzfläche mit der intrinsischen Schicht aufweist und an der Grenzfläche eine Bandlücke aufweist, die gleich der der intrinsischen Schicht an der Grenzfläche ist.

13. Photovoltaikdiode nach Anspruch 11 oder Anspruch 12, bei der die Bandlücke der abgestuften Schicht der Basis eine Grenzfläche mit der intrinsischen Schicht aufweist und an der Grenzfläche eine selbe Zusammensetzung wie die der intrinsischen Schicht an der Grenzfläche aufweist.

14. Photovoltaikdiode nach einem der vorhergehenden Ansprüche, bei der die Emitterschicht eine Schicht aus Galliumarsenid aufweist und bei der die Emitterschicht eine Schicht aus Aluminiumgalliumarsenid aufweist.

15. Photovoltaikdiode nach einem der vorhergehenden Ansprüche, bei der die intrinsische Schicht eine Bandlücke in dem Bereich 0,7 bis 1,4 eV aufweist und bei der die Basisschicht eine Bandlücke in dem Bereich 0,7 bis 1,0 eV aufweist.

16. Photovoltaikdiode nach einem der vorhergehenden Ansprüche, bei der die Emitterschicht, die intrinsische Schicht und die Basisschicht aneinander gitterangepasst sind.

17. Solarzelle mit einer Photovoltaikdiode nach einem der vorhergehenden Ansprüche.

18. Mehrfachphotovoltaikvorrichtung mit einer Photovoltaikdiode nach einem der Ansprüche 1 bis 16 als einen ihrer Übergänge.

19. Mehrfachphotovoltaikvorrichtung mit einer ersten Photovoltaikdiode nach einem der Ansprüche 1 bis 16 als einen ihrer Übergänge und mit einer zweiten Photovoltaikdiode nach einem der Ansprüche 1 bis 16 als einen ihrer Übergänge, wobei die Basis der ersten Photovoltaikdiode und die Basis der zweiten Photovoltaikdiode unterschiedliche Bandlücken aufweisen.

20. Verfahren zum Erzeugen von Elektrizität unter Verwendung einer Photovoltaikdiode nach einem der Ansprüche 1 bis 16, mit:
Leiten von Licht in die Photovoltaikdiode durch die Emitterschicht in der Richtung der intrinsischen Schicht und der Basisschicht,
Absorbieren des Lichts in der intrinsischen Schicht zum Erzeugen von Photoladungsträgern und
Trennen der Photoladungsträger durch die Diode zum Erzeugen von Elektrizität.

## Revendications

1. Diode photovoltaïque, 300, comprenant :
une couche émettrice, 301, de matériau semi-conducteur du groupe III-V dopé, ayant un premier type de conductivité et une première bande interdite dans au moins une partie de la couche,
une couche intrinsèque, 302, de matériau semi-conducteur du groupe III-V à nitrure dilué ayant une composition donnée par la formule Ga_{1-z}In_{z}NₓAs_{y}Sb_{1-x-y}, où 0 < z < 0,20, 0,01 < x < 0,05 et y > 0,80, ayant une deuxième bande interdite,
une couche de base, 303, de matériau semi-conducteur ayant une troisième bande interdite et un second type de conductivité opposé au premier type de conductivité,
dans laquelle les couches émettrice, intrinsèque et de base forment une jonction de diode, et
dans laquelle la première bande interdite est supérieure à la deuxième bande interdite,
dans laquelle la couche émettrice comprend une couche émettrice à large bande interdite, 301a, de matériau semi-conducteur du groupe III-V ayant la première bande interdite et une couche émettrice à bande interdite étroite, 301b, entre la couche émettrice à large bande interdite et la couche intrinsèque, la couche émettrice à bande étroite ayant le premier type de conductivité et étant en un matériau semi-conducteur du groupe III-V à nitrure dilué ayant une composition donnée par la formule Ga_{1-z}In_{z}NₓAs_{y}Sb_{1-x-y}, où 0 < z < 0,20, 0,01 < x < 0,05 et y > 0,80, dans laquelle la couche émettrice à bande étroite a une quatrième bande interdite qui est plus petite que la première bande interdite,
**caractérisée en ce que** la couche émettrice à bande interdite étroite a une épaisseur inférieure à une longueur de diffusion des porteurs minoritaires.

2. Diode photovoltaïque selon la revendication 1, dans laquelle la couche de base est une couche de matériau semi-conducteur du groupe III-V à nitrure dilué ayant une composition donnée par la formule Ga_{1-z}In_{z}NₓAs_{y}Sb_{1-x-y}, où 0 < z < 0,20, 0,01 < x < 0,05 et y > 0,80.

3. Diode photovoltaïque selon la revendication 1, dans laquelle la quatrième bande interdite est identique à la deuxième bande interdite.

4. Diode photovoltaïque selon la revendication 1, dans laquelle la quatrième bande interdite est entre les première et deuxième bandes interdites.

5. Diode photovoltaïque selon l'une quelconque des revendications 1 à 4, dans laquelle la couche émettrice à bande interdite étroite est en accord de maille avec la couche émettrice à bande interdite plus large.

6. Diode photovoltaïque selon l'une quelconque des revendications 1 à 5, dans laquelle la couche émettrice à bande interdite étroite est en accord de maille avec la couche intrinsèque.

7. Diode photovoltaïque selon l'une quelconque des revendications 1 à 6, dans laquelle la couche émettrice à largeur de bande étroite a une épaisseur inférieure à 200 nm.

8. Diode photovoltaïque selon la revendication 7, dans laquelle la couche émettrice à bande interdite étroite fait 100 nm d'épaisseur.

9. Diode photovoltaïque selon l'une quelconque des revendications précédentes, dans laquelle les couches intrinsèque et de base ont la même composition de matériau semi-conducteur.

10. Diode photovoltaïque selon l'une quelconque des revendications précédentes, dans laquelle les couches intrinsèques et de base ont la même bande interdite l'une et l'autre.

11. Diode photovoltaïque selon l'une quelconque des revendications 1 à 8, dans laquelle la couche de base comprend une couche de matériau semi-conducteur du groupe III-V à nitrure dilué graduée ayant une composition et une largeur de bande graduées à travers l'épaisseur de la couche graduée, la composition à travers la couche graduée se trouvant dans la formule Ga_{1-z}In_{z}NₓAs_{y}Sb_{1-x-y}, où 0 < z < 0,20, 0,01 < x < 0,05, et y > 0,80.

12. Diode photovoltaïque selon la revendication 11, dans laquelle la bande interdite de la couche graduée de la base a une interface avec la couche intrinsèque et au niveau de cette interface a une bande interdite égale à celle de la couche intrinsèque au niveau de cette interface.

13. Diode photovoltaïque selon la revendication 11 ou la revendication 12, dans laquelle la bande interdite de la couche graduée de la base a une interface avec la couche intrinsèque et au niveau de cette interface a une composition identique à celle de la couche intrinsèque au niveau de cette interface.

14. Diode photovoltaïque selon l'une quelconque des revendications précédentes, dans laquelle la couche émettrice comprend une couche d'arséniure de gallium, et dans laquelle la couche émettrice comprend une couche d'arséniure d'aluminium et de gallium.

15. Diode photovoltaïque selon l'une quelconque des revendications précédentes, dans laquelle la couche intrinsèque a une bande interdite dans la plage de 0,7 à 1,4 eV, et dans laquelle la couche de base a une bande interdite dans la plage de 0,7 à 1,0 eV.

16. Diode photovoltaïque selon l'une quelconque des revendications précédentes, dans laquelle les couches émettrice, intrinsèque et de base sont en accord de maille les unes avec les autres.

17. Cellule solaire comprenant une diode photovoltaïque selon l'une quelconque des revendications précédentes.

18. Dispositif photovoltaïque multijonction comprenant une diode photovoltaïque selon l'une quelconque des revendications 1 à 16 en tant qu'une de ses jonctions.

19. Dispositif photovoltaïque multijonction comprenant une première diode photovoltaïque selon l'une quelconque des revendications 1 à 16 en tant qu'une de ses jonctions, et comprenant une seconde diode photovoltaïque selon l'une quelconque des revendications 1 à 16 en tant qu'une de ses jonctions, dans laquelle les bases des première et seconde diodes photovoltaïques ont différentes bandes interdites.

20. Procédé de génération d'électricité utilisant une diode photovoltaïque selon l'une quelconque des revendications 1 à 16 comprenant :
l'orientation d'une lumière dans la diode photovoltaïque à travers la couche émettrice dans la direction des couches intrinsèque et de base,
l'absorption de la lumière dans la couche intrinsèque pour générer des photoporteurs, et
la séparation par la diode des photoporteurs pour générer de l'électricité.
